# EUROPÄISCHE PATENTANMELDUNG

(11) **EP 2 811 640 A2**
(43) Veröffentlichungstag der Anmeldung: **10.12.2014**
(21) Anmeldenummer: 14158697.4
(22) Anmeldetag: 11.03.2014
(51) Int. Cl.: H02M 7/00

(54) **Leistungshalbleitereinrichtung**

(30) Priorität: 17.04.2013 DE 102013103866
(71) Anmelder: SEMIKRON Elektronik GmbH & Co. KG, 90431 Nürnberg (DE)
(72) Erfinder: Ehler, Ralf, 91459 Markt Erlbach (DE); Beckedahl, Peter, 90522 Oberasbach (DE)

(57) **Zusammenfassung**

Die Erfindung betrifft ein Leistungshalbleitereinrichtung mit einem eine bauliche Einheit bildenden Leistungshalbleitermodul und einem eine bauliche Einheit bildenden Kondensatormodul, wobei das Leistungshalbleitermodul einen ersten Außenanschlussabschnitt und einen zweiten Außenanschlussabschnitt aufweist, wobei das Kondensatormodul einen elektrischen Kondensator aufweist, wobei das Kondensatormodul mit dem Leistungshalbleitermodul lösbar mechanisch verbunden ist, wobei das Kondensatormodul ein drittes Gleichspannungslastanschlusselement, das mit einem ersten elektrischen Anschluss des Kondensators elektrisch leitend verbunden ist und ein viertes Gleichspannungslastanschlusselement, das mit einem zweiten elektrischen Anschluss des Kondensators elektrisch leitend verbunden ist, aufweist, wobei das dritte Gleichspannungslastanschlusselement einen dritten Außenanschlussabschnitt und das vierte Gleichspannungslastanschlusselement einen vierten Außenanschlussabschnitt aufweist, wobei der erste Außenanschlussabschnitt mit dem dritten Außenanschlussabschnitt einen elektrisch leitenden Kontakt aufweist und der zweite Außenanschlussabschnitt mit dem vierten Außenanschlussabschnitt einen elektrisch leitenden Kontakt aufweist. Die Erfindung schafft eine einfach und schnell herstellbare Leistungshalbleitereinrichtung bei der ein Leistungshalbleitermodul einfach und schnell mit unterschiedlichen Kondensatoren zuverlässig elektrisch leitend verbunden werden kann.

## Beschreibung

Die Erfindung betrifft eine Leistungshalbleitereinrichtung.

Bei aus dem Stand der Technik bekannten Leistungshalbleitermodulen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Techniküblich werden z.B. zur Realisierung eines Gleich- bzw. Wechselrichters ein einzelnes oder mehrere Leistungshalbleitermodule mit mindestens einem Kondensator, der in der Regel als Zwischenkeiskondensator dient, elektrisch leitend verbunden und solchermaßen eine Leistungshalbleitereinrichtung ausgebildet.

Zur Kühlung der Leistungshalbleiterbauelemente wird dabei häufig ein von einer Flüssigkeit durchströmbarer Kühlkörper verwendet, der thermisch an die Leistungshalbleiterbauelemente angekoppelt ist. Die beim Betrieb der Leistungshalbleitereinrichtung auftretenden hohen Lastströme führen auch zu einer Erwärmung des Kondensators.

Die Kapazität und die Bauart des Kondensators hängen insbesondere von der jeweiligen konkreten Anwendung der Leistungshalbleitereinrichtung ab, so dass das Leistungshalbleitermodul oft mit unterschiedlichen Kondensatoren elektrisch leitend verbunden werden muss, was zu einer Vielzahl von Leistungshalbleitereinrichtungen und somit zu einem erheblichen Herstellungsaufwand führt.

Es ist Aufgabe der Erfindung eine einfach und schnell herstellbare Leistungshalbleitereinrichtung zu schaffen, bei der ein Leistungshalbleitermodul einfach und schnell mit unterschiedlichen Kondensatoren zuverlässig elektrisch leitend verbunden werden kann.

Diese Aufgabe wird gelöst durch eine Leistungshalbleitereinrichtung mit einem eine bauliche Einheit bildenden Leistungshalbleitermodul und einem eine bauliche Einheit bildenden Kondensatormodul, wobei das Leistungshalbleitermodul ein Substrat und auf dem Substrat angeordnete und mit dem Substrat verbundene Leistungshalbleiterbauelemente aufweist, wobei das Leistungshalbleitermodul einen von einer Flüssigkeit durchströmbaren Kühlkörper aufweist, der die Leistungshalbleiterbauelemente kühlt, wobei das Leistungshalbleitermodul ein erstes Gehäuse aufweist, durch das ein erstes und ein zweites elektrisch leitendes Gleichspannungslastanschlusselement, die jeweilig mit mindestens einem Leistungshalbleiterbauelement elektrisch leitend verbunden sind, hindurchverläuft, wobei das erste Gleichspannungslastanschlusselement einen außerhalb des ersten Gehäuses auf einer ersten Seite des ersten Gehäuses angeordneten ersten Außenanschlussabschnitt und das zweite Gleichspannungslastanschlusselement einen außerhalb des ersten Gehäuses auf der ersten Seite des ersten Gehäuses angeordneten zweiten Außenanschlussabschnitt aufweist, wobei das Kondensatormodul ein zweites Gehäuse und einen in dem zweiten Gehäuse angeordneten elektrischen Kondensator aufweist, wobei das Kondensatormodul mit dem Leistungshalbleitermodul lösbar mechanisch verbunden ist, wobei das Kondensatormodul ein drittes Gleichspannungslastanschlusselement, das mit einem ersten elektrischen Anschluss des Kondensators elektrisch leitend verbunden ist und ein viertes Gleichspannungslastanschlusselement, das mit einem zweiten elektrischen Anschluss des Kondensators elektrisch leitend verbunden ist, aufweist, wobei das dritte Gleichspannungslastanschlusselement einen dritten Außenanschlussabschnitt und das vierte Gleichspannungslastanschlusselement einen vierten Außenanschlussabschnitt aufweist, wobei der dritte und vierte Außenanschlussabschnitt auf einer ersten Seite des zweiten Gehäuses angeordnet ist, wobei die erste Seite des zweiten Gehäuses der ersten Seite des ersten Gehäuses zugewandt angeordnet ist, wobei der erste Außenanschlussabschnitt mit dem dritten Außenanschlussabschnitt einen elektrisch leitenden Kontakt aufweist und der zweite Außenanschlussabschnitt mit dem vierten Außenanschlussabschnitt einen elektrisch leitenden Kontakt aufweist.

Vorteilhafte Ausbildungen der Erfindung ergeben sich aus den abhängigen Ansprüchen.

Es erweist sich als vorteilhaft, wenn das dritte Gleichspannungslastanschlusselement einen fünften Außenanschlussabschnitt und das vierte Gleichspannungslastanschlusselement einen sechsten Außenanschlussabschnitt aufweist, wobei der fünfte und sechste Außenanschlussabschnitt auf einer der ersten Seite des zweiten Gehäuses abgewandt angeordneten zweiten Seite des zweiten Gehäuses angeordnet ist, wobei zwischen dem dritten und fünften Außenanschlussabschnitt ein flacher erster Verbindungsabschnitt des dritten Gleichspannungslastanschlusselements und zwischen dem vierten und sechsten Außenanschlussabschnitt ein flacher zweiter Verbindungsabschnitt des vierten Gleichspannungslastanschlusselements angeordnet ist, wobei zwischen dem ersten und zweiten Verbindungsabschnitt ein Spalt ausgebildet ist. Hierdurch wird ein Kondensatormodul ermöglicht, das nur eine sehr geringe Induktivität aufweist.

Weiterhin erweist es sich als vorteilhaft, wenn der elektrisch leitende Kontakt des ersten Außenanschlussabschnitts mit dem dritten Außenanschlussabschnitt und der elektrisch leitende Kontakt des zweiten Außenanschlussabschnitts mit dem vierten Außenanschlussabschnitt als Einpresskontakt ausgebildet ist. Hierdurch wird eine einfache, schnelle und zuverlässige elektrische Kontaktierung des Kondensatormoduls mit dem Leistungshalbleitermodul ermöglicht. Auf eine nur schwer zugängliche Schraubverbindung, zur Realisierung des elektrisch leitenden Kontakts des ersten Außenanschlussabschnitts mit dem dritten Außenanschlussabschnitt und des elektrisch leitende Kontakts des zweiten Außenanschlussabschnitts mit dem vierten Außenanschlussabschnitt, kann somit verzichtet werden.

Weiterhin erweist es sich als vorteilhaft, wenn der dritte Außenanschlussabschnitt ein erstes Loch und der vierte Au ßenanschlussabschnitt ein zweites Loch aufweist, wobei der erste Außenanschlussabschnitt einen ersten Pressstift mit einem senkrecht zur axialen Richtung des ersten Pressstifts verformbaren ersten Verformungsabschnitt und der zweite Außenanschlussabschnitt einen zweiten Pressstift mit einem senkrecht zur axialen Richtung des zweiten Pressstifts verformbaren zweiten Verformungsabschnitt aufweist, wobei der erste Verformungsabschnitt im ersten Loch angeordnet ist und in senkrechte Richtung zur axialen Richtung des ersten Pressstifts gegen eine Innenwand des ersten Lochs drückt und solchermaßen den elektrischen leitenden Kontakt zwischen dem ersten und dritten Außenanschlussabschnitt bewirkt, wobei der zweite Verformungsabschnitt im zweiten Loch angeordnet ist und in senkrechte Richtung zur axialen Richtung des zweiten Pressstifts gegen eine Innenwand des zweiten Lochs drückt und solchermaßen den elektrischen leitenden Kontakt zwischen dem zweiten und vierten Außenanschlussabschnitt bewirkt. Hierdurch wird eine einfache, schnelle und zuverlässige elektrische Kontaktierung des Kondensatormoduls mit dem Leistungshalbleitermodul ermöglicht.

Ferner erweist es sich als vorteilhaft, wenn der erste Außenanschlussabschnitt ein erstes Loch und der zweite Außenanschlussabschnitt ein zweites Loch aufweist, wobei der dritte Außenanschlussabschnitt einen ersten Pressstift mit einem senkrecht zur axialen Richtung des ersten Pressstifts verformbaren ersten Verformungsabschnitt und der vierte Außenanschlussabschnitt einen zweiten Pressstift mit einem senkrecht zur axialen Richtung des zweiten Pressstifts verformbaren zweiten Verformungsabschnitt aufweist, wobei der erste Verformungsabschnitt im ersten Loch angeordnet ist und in senkrechte Richtung zur axialen Richtung des ersten Pressstifts gegen eine Innenwand des ersten Lochs drückt und solchermaßen den elektrischen leitenden Kontakt zwischen dem ersten und dritten Außenanschlussabschnitt bewirkt, wobei der zweite Verformungsabschnitt im zweiten Loch angeordnet ist und in senkrechte Richtung zur axialen Richtung des zweiten Pressstifts gegen eine Innenwand des zweiten Lochs drückt und solchermaßen den elektrischen leitenden Kontakt zwischen dem zweiten und vierten Außenanschlussabschnitt bewirkt. Hierdurch wird eine einfache, schnelle und zuverlässige elektrische Kontaktierung des Kondensatormoduls mit dem Leistungshalbleitermodul ermöglicht.

Weiterhin erweist es sich als vorteilhaft, wenn das Kondensatormodul mit dem Leistungshalbleitermodul lösbar mechanisch verbunden ist, indem das Kondensatormodul mit dem Kühlkörper des Leistungshalbleitermoduls lösbar mechanisch verbunden ist. Hierdurch wird eine zuverlässige Kühlung des Kondensators des Kondensatormoduls mittels des Kühlkörper des Leistungshalbleitermoduls ermöglicht.

Weiterhin erweist sich ein Leistungshalbleitereinrichtungssystem, das aneinander angeordnete erfindungsgemäße Leistungshalbleitereinrichtungen aufweist, wobei die Kühlkörper der Leistungshalbleitereinrichtungen miteinander lösbar mechanisch verbunden sind und die Kühlkörper jeweilig erste Flüssigkeitskanalöffnungen und zweite Flüssigkeitskanalöffnungen aufweisen, wobei die Kühlkörper der Leistungshalbleitereinrichtungen derart aneinander angeordnet sind, dass die ersten Flüssigkeitskanalöffnungen benachbart angeordneter Kühlkörper zueinander fluchtend angeordnet sind und dass die zweiten Flüssigkeitskanalöffnungen benachbart angeordneter Kühlkörper zueinander fluchtend angeordnet sind, als vorteilhaft. Hierdurch wird ein kompakt aufgebautes und an individuelle Anforderungen und elektrische Leistungen auf einfache Art und Weise anpassbares modular aufgebautes Leistungshalbleitereinrichtungssystem geschaffen.

Ferner erweist es sich als vorteilhaft, wenn bei den Leistungshalbleitereinrichtungen des Leistungshalbleitereinrichtungssystems das dritte Gleichspannungslastanschlusselement einen fünften Außenanschlussabschnitt und das vierte Gleichspannungslastanschlusselement einen sechsten Außenanschlussabschnitt aufweist, wobei der fünfte und sechste Außenanschlussabschnitt auf einer der ersten Seite des zweiten Gehäuses gegenüberliegend angeordneten zweiten Seite des zweiten Gehäuses angeordnet ist, wobei zwischen dem dritten und fünften Außenanschlussabschnitt ein flacher erster Verbindungsabschnitt des dritten Gleichspannungslastanschlusselements und zwischen dem vierten und sechsten Außenanschlussabschnitt ein flacher zweiter Verbindungsabschnitt des vierten Gleichspannungslastanschlusselements angeordnet ist, wobei zwischen dem ersten und zweiten Verbindungsabschnitt ein Spalt ausgebildet ist, wobei zumindest ein Teil der fünften Außenanschlussabschnitte der Leistungshalbleitereinrichtungen elektrisch leitend mit einem ersten elektrisch leitenden Verbindungselement verbunden sind und zumindest ein Teil der sechsten Außenanschlussabschnitte der Leistungshalbleitereinrichtungen elektrisch leitend mit einem zweiten elektrisch leitenden Verbindungselement verbunden sind. Hierdurch wird eine elektrisch leitende Verbindung der Kondensatoren mehrerer Leistungshalbleitereinrichtungen ermöglicht und somit z.B. aus den Kondensatoren ein gemeinsamer Zwischenkreiskondensator ausgebildet, der eine sehr hohe Kapazität aufweist.

Weiterhin erweist es sich als vorteilhaft, wenn das erste und das zweite elektrisch leitende Verbindungselement flach ausgebildet ist und zwischen dem ersten und dem zweiten elektrisch leitenden Verbindungselement ein Spalt ausgebildet ist. Hierdurch wird eine besonders niederinduktive elektrische leitende Verbindung der Kondensatoren mehrerer Leistungshalbleitereinrichtungen ermöglicht.

Der erfindungsgemäße Aufbau der Leistungshalbleitereinrichtung ermöglicht in Zusammenwirken mit der erfindungsgemäßen Realisierung der mechanischen und elektrischen Verbindung zwischen dem Leistungshalbleitermodul und dem Kondensatormodul einfach und schnell ein Leistungshalbleitermodul mit unterschiedlichen Kondensatormodulen, die sich z.B. in der Kapazität, Anzahl und/oder der Bauart ihrer Kondensatoren unterscheiden, zu verbinden und schafft somit eine einfach und schnell herstellbare und an verschiedene Anwendungen anpassbare Leistungshalbleitereinrichtung.

Ausführungsbeispiele der Erfindung ist in den Figuren dargestellt und werden im Folgenden näher erläutert. Dabei zeigen:
- FIG 1: eine perspektivische Darstellung eines eine bauliche Einheit bildenden Leistungshalbleitermoduls,
- FIG 2: eine schematisierte Schnittdarstellung eines Substrat eines Leistungshalbleitermoduls und der mit dem Substrat verbundenen Elemente des Leistungshalbleitermoduls,
- FIG 3: eine perspektivische Darstellung eines eine bauliche Einheit bildenden Kondensatormoduls,
- FIG 4: eine perspektivische Darstellung eines eine bauliche Einheit bildenden Kondensatormoduls ohne Gehäuse,
- FIG 5: eine schematisierte Schnittdarstellung eines eine bauliche Einheit bildenden Kondensatormoduls ohne Gehäuse,
- FIG 6: perspektivische Darstellung eines Gleichspannungslastanschlusselements,
- FIG 7: eine Schnittdarstellung eines dritten bzw. vierten Außenanschlussabschnitts in dessen Löcher Pressstifte angeordnet sind,
- FIG 8: eine perspektivische Darstellung einer weiteren Ausbildung eines eine bauliche Einheit bildenden Leistungshalbleitermoduls,
- FIG 9: eine perspektivische Darstellung einer weiteren Ausbildung eines eine bauliche Einheit bildenden Kondensatormoduls,
- FIG 10: eine perspektivische Darstellung eines mehrere Leistungshalbleitereinrichtungen aufweisenden Leistungshalbleitereinrichtungssystems in einer Ansicht von vorne auf das Leistungshalbleitereinrichtungssystem und
- FIG 11: eine perspektivische Darstellung eines mehrere Leistungshalbleitereinrichtungen aufweisenden Leistungshalbleitereinrichtungssystems in einer Ansicht von hinten auf das Leistungshalbleitereinrichtungssystem.

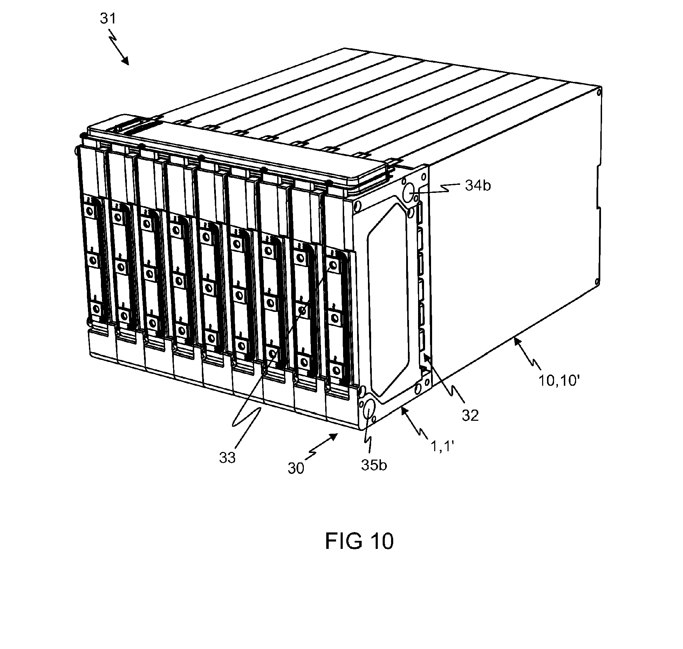

Die erfindungsgemäße Leistungshalbleitereinrichtung 30 weist ein eine bauliche Einheit bildendes Leistungshalbleitermodul 1 bzw. 1' und ein eine bauliche Einheit bildendes Kondensatormodul 10 bzw. 10' auf (siehe FIG 10).

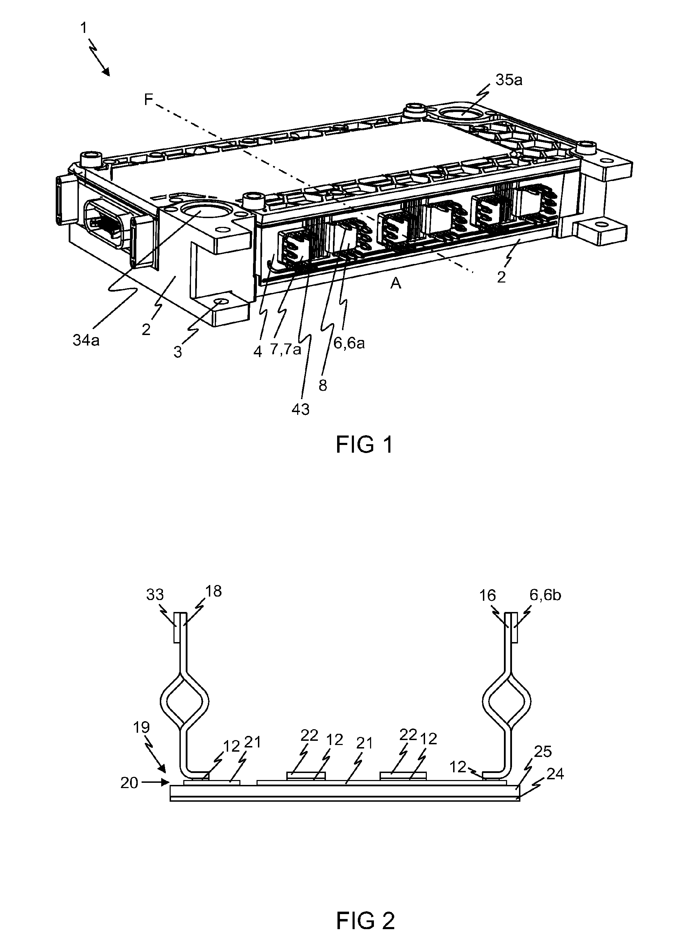

In FIG 1 ist ein Leistungshalbleitermoduls 1 dargestellt. In FIG 2 zeigt eine schematisierte Schnittdarstellung eines Substrats 19 des Leistungshalbleitermoduls 1 und der mit dem Substrat 19 verbundenen Elemente des Leistungshalbleitermoduls 1, wobei der Schnitt entlang der in FIG 1 dargestellten Linie F verläuft. Das Leistungshalbleitermodul 1 weist ein erstes Gehäuse 4 auf, das die Leistungshalbleiterbauelemente 22 des Leistungshalbleitermoduls 1 zumindest in lateraler Richtung umschließt. Das erste Gehäuse 4 weist im Rahmen des Ausführungsbeispiels drei zur Durchführung von Gleichströmen dienende Ausnehmungen auf, durch die jeweilig ein erstes und ein zweites elektrisch leitendes Gleichspannungslastanschlusselement 6 und 7, die jeweilig mit mindestens einem Leistungshalbleiterbauelement elektrisch leitend verbunden sind, hindurchverlaufen. Es sei an dieser Stelle angemerkt, dass beim Ausführungsbeispiel ein Leistungshalbleitermodul 1 dargestellt ist, bei dem eine Gleichspannung in drei 1-phasige Wechselspannungen wechselgerichtet wird bzw. drei 1-phasige Wechselspannungen in eine Gleichspannung gleichgerichtet werden. Die folgende Beschreibung beschreibt dabei beispielhaft den Aufbau des Leitungshalbleitermoduls 1, hinsichtlich eines Substrats und der dem Substrat zugeordneten Elemente, bezüglich der Erzeugung einer 1-phasigen Wechselspannung. Das Substrat 19 bzw. die betreffende Anordnung zur Erzeugung der 1-phasigen Wechselspannung ist dabei im Rahmen des Ausführungsbeispiels in identischer Ausführung dreifach vorhanden, so dass im Rahmen des Ausführungsbeispiels, wie schon oben beschrieben, vom Leitungshalbleitermodul 1 aus einer Gleichspannung drei 1-phasige Wechselspannungen erzeugt werden bzw. drei 1-phasige Wechselspannungen in eine Gleichspannung gleichgerichtet werden.

Das erste Gehäuse 4 besteht vorzugsweise aus Kunststoff und liegt vorzugsweise in Form eines Spritzgussteils vor.

Das Leistungshalbleitermodul 1 weist ein Substrat 19, das beim Ausführungsbeispiel in Form eines DCB-Substrats vorliegt und auf dem Substrat 19 angeordnete und mit dem Substrat 19 verbundene Leistungshalbleiterbauelemente 22 auf. Das jeweilige Leistungshalbleiterbauelement liegt vorzugsweise in Form eines Leistungshalbleiterschalters oder einer Diode vor. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor. Beim Ausführungsbeispiel weisen die Leistungshalbleiterbauelemente 22 an Ihrer dem Substrat 19 zugewandten Seite jeweilig einen ersten Leistungshalbleiterlaststromanschluss (z.B. Kollektor) und an Ihrer dem Substrat 19 abgewandten Seite jeweilig einen zweiten Leistungshalbleiterlaststromanschluss (z.B. Emitter) auf.

Das Substrat 19 weist einen Isolierstoffkörper 25 und eine auf einer ersten Seite des Isolierstoffkörpers 25 angeordnete und mit dem Isolierstoffkörper 25 verbundene elektrisch leitende strukturierte erste Leitungsschicht 20 auf, die Leiterbahnen 21 ausbildet. Vorzugsweise weist das Substrat 19 eine elektrisch leitende, vorzugsweise unstrukturierte zweite Leitungsschicht 24 auf, wobei der Isolierstoffkörper 25 zwischen der strukturierten ersten Leitungsschicht 20 und der zweiten Leitungsschicht 24 angeordnet ist. Die strukturierte erste Leitungsschicht 20 des Substrats 19 kann z.B. aus Kupfer bestehen. Das Substrat 19 kann z.B., wie beim Ausführungsbeispiel, in Form eines Direct Copper Bonded Substrats (DCB-Substrat) oder in Form eines Insulated Metal Substrats (IMS) vorliegen. Im Falle eines DCB-Substrats kann der Isolierstoffkörper 25 z.B. aus einer Keramik bestehen und die zweite Leitungsschicht 24 des Substrats 19 z.B. aus Kupfer bestehen. Im Falle eines Insulated Metal Substrats kann der Isolierstoffkörper 25 z.B. aus einer Schicht aus Polyimid oder Epoxy bestehen und die zweite Leitungsschicht 24 des Substrats 19 aus einem Metallformkörper bestehen. Der Metallformkörper kann z.B. aus Aluminium oder einer Aluminiumlegierung bestehen.

Weiterhin weist das Leistungshalbleitermodul 1 elektrisch leitende Gleichspannungsverbindungselemente 16 auf, die das Substrat 19, genauer ausgedrückt die erste Leitungsschicht 20 des Substrats 19 mit den jeweilig zugeordneten elektrisch leitenden Gleichspannungslastanschlusselementen 6 und 7 verbinden. Weiterhin weist das Leistungshalbleitermodul 1 ein Wechselspannungsverbindungselement 18 auf, das das Substrat 19, genauer ausgedrückt die erste Leitungsschicht 20 des Substrat 19 mit einem zugeordneten elektrisch leitenden Wechselspannungslastanschlusselement 33 verbindet (siehe auch FIG 10). In FIG 2 sind der Übersichtlichkeit halber nur die mit dem Gleichspannungslastanschlusselement 16 bzw. mit dem Wechselspannungsverbindungselement 18, vorzugsweise mittels einer Schweißverbindung, verbunden Innenabschnitte des Gleichspannungslastanschlusselements 16 bzw. des Wechselspannungslastanschlusselements 33 dargestellt. Die Lastströme, welche durch die Gleichspannungslastanschlusselemente 6 und 7 und durch das Wechselspannungslastanschlusselement 33 fließen, weisen dabei in der Regel, im Gegensatz zu Hilfsströmen, welche z.B. zur Ansteuerung der Leistungshalbleiterbauelemente dienen, wenn die Leistungshalbleiterbauelemente als Leistungshalbleiterschalter ausgebildet sind, eine hohe Stromstärke auf.

Beim Ausführungsbeispiel weist beim Betrieb der erfindungsgemäßen Leistungshalbleitereinrichtung das erste Gleichspannungslastanschlusselement 6 ein positives elektrisches Spannungspotential und das zweite Gleichspannungslastanschlusselement 7 ein negatives elektrisches Spannungspotential auf.

Vorzugsweise ist die Verbindung zwischen den Leistungshalbleiterbauelementen 22 und dem Substrat 19, und/oder zwischen den Gleichspannungsverbindungselementen 16 und 17 und dem Substrat 19, und/oder zwischen dem zwischen dem Wechselspannungsverbindungselement 18 und dem Substrat 19, jeweilig als stoffschlüssige oder kraftschlüssige Verbindung realisiert.

Im Rahmen des Ausführungsbeispiels sind die im vorstehenden Absatz genannten Verbindungen als Sinterverbindungen realisiert, so dass beim Ausführungsbeispiel zwischen den Leistungshalbleiterbauelementen 22 und dem Substrat 19, und zwischen den Gleichspannungsverbindungselementen und dem Substrat 19, und zwischen dem zwischen dem Wechselspannungsverbindungselement 18 und dem Substrat 19, jeweilig eine Sinterschicht 12 angeordnet ist.

Es sei angemerkt, dass die Leistungshalbleiterbauelemente 22 an Ihrer dem Substrat 19 abgewandten Seite, mittels z.B. Bonddrähten und/oder einem Folienverbund miteinander und mit den Leiterbahnen 21 des Substrats 19, entsprechend der gewünschten elektrischen Schaltung, welche das Leistungshalbleitermodul 1 realisieren soll, elektrisch leitend miteinander verbunden sind. Der Übersichtlichkeit halber sind diese elektrischen Verbindungen in FIG 2 nicht dargestellt.

Weiterhin weist das Leistungshalbleitermodul 1 einen von einer Flüssigkeit durchströmbaren Kühlkörper 2 auf, der die Leistungshalbleiterbauelemente 22 kühlt. Die Leistungshalbleiterbauelemente 22 sind hierzu thermisch leitend an den Kühlkörper 2 angekoppelt. Vorzugsweise ist hierzu die zweite Leitungsschicht 24 des Substrats 19 mit dem Kühlkörper 2 verbunden. Der Kühlkörper 2 weist im Rahmen des Ausführungsbeispiels erste Flüssigkeitskanalöffnungen 34a und 34b und zweite Flüssigkeitskanalöffnungen 35a und 35b auf (siehe auch FIG 10). Die ersten Flüssigkeitskanalöffnungen 34a und 34b sind zueinander fluchtend angeordnet. Weiterhin sind die zweiten Flüssigkeitskanalöffnungen 35a und 35b zueinander fluchtend angeordnet. Die ersten Flüssigkeitskanalöffnungen 34a und 34b sind beim Ausführungsbeispiel über mindestens einen durch den Kühlkörper 2 verlaufenden Kühlkanal mit den zweiten Flüssigkeitskanalöffnungen 35a und 35b verbunden.

Das erste und das zweite elektrisch leitende Gleichspannungslastanschlusselement 6 und 7 verläuft durch das erste Gehäuse 4 hindurch, wobei wie schon beschrieben, das erste und das zweite elektrisch leitende Gleichspannungslastanschlusselement 6 und 7 jeweilig mit mindestens einem Leistungshalbleiterbauelement 22 elektrisch leitend verbunden sind. Das erste Gleichspannungslastanschlusselement 6 weist einen außerhalb des ersten Gehäuses 4 auf einer ersten Seite A des ersten Gehäuses 4 angeordneten ersten Außenanschlussabschnitt 6a und das zweite Gleichspannungslastanschlusselement 7 weist einen außerhalb des ersten Gehäuses 4 auf der ersten Seite A des ersten Gehäuses 4 angeordneten zweiten Außenanschlussabschnitt 7a auf.

Es sei an dieser Stelle weiterhin angemerkt, dass im Sinne der vorliegenden Erfindung unter dem Ausdruck, dass zwei Elemente elektrisch leitend verbunden sind bzw. miteinander elektrisch leitend verbunden werden, sowohl eine direkte elektrisch leitende Verbindung von zwei Elementen, mittels z.B. einer Schweiß-, Löt- oder Sinterverbindung, die zwischen den beiden Elementen besteht, als auch eine indirekte elektrisch leitende Verbindung, mittels z.B. einem oder mehreren Leitungselementen, wie z.B. einer Leiterbahn, einem Bonddraht, einem elektrisch leitenden Folienverbund, einer Stromschiene, einem Gleichspannungsverbindungselement, einem Wechselspannungsverbindungselement oder einem Kabel, die die beiden Elemente elektrisch miteinander verbinden, so dass eine bidirektionaler elektrischer Stromfluss zwischen den beiden elektrisch miteinander leitend verbunden Elementen möglich ist, verstanden wird.

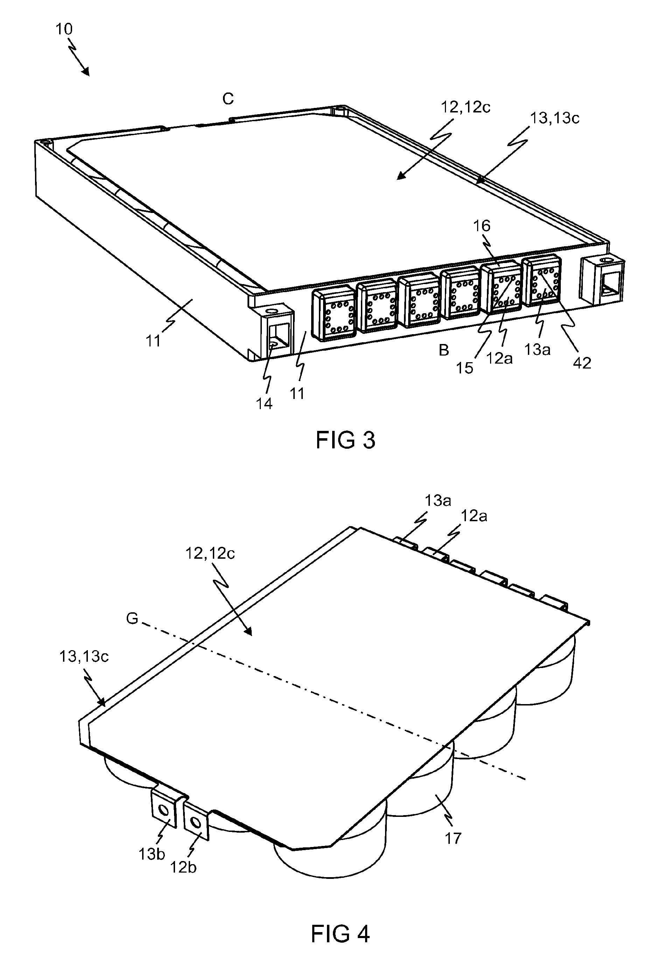

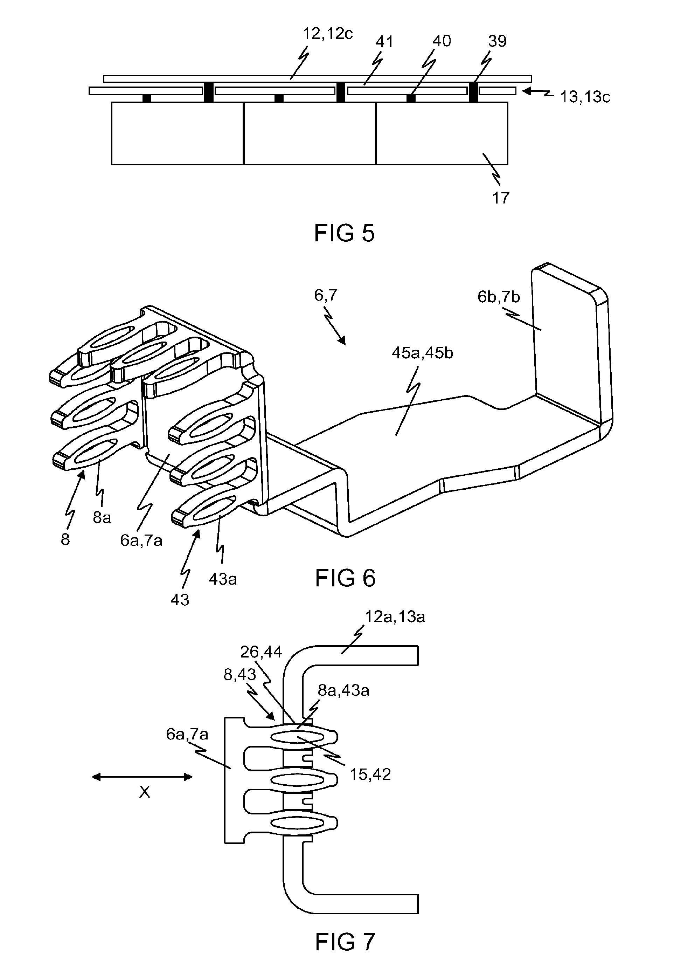

In FIG 3 ist eine perspektivische Darstellung des Kondensatormoduls 10 dargestellt, wobei in FIG 4 das Kondensatormodul 10 ohne Gehäuse dargestellt ist. In FIG 5 ist eine schematisierte Schnittdarstellung des Kondensatormoduls 10 dargestellt, wobei der Schnitt entlang der in FIG 4 dargestellten Linie G verläuft.

Das Kondensatormodul 10 weist ein zweites Gehäuse 11 und in dem zweiten Gehäuse 11 angeordnete elektrische Kondensatoren 17 auf, wobei in FIG 4 und FIG 5 nur ein einzelner Kondensator 17 mit einem Bezugszeichen versehen ist. Es sei dabei angemerkt, dass im einfachsten Fall das Kondensatormodul 10 auch nur einen einzelnen Kondensator 17 aufweisen kann. Weiterhin sei angemerkt, dass jeder Kondensator auch aus elektrisch in Reihe und/oder parallel verschalteter Teilkondensatoren bestehen kann. Das Kondensatormodul 10 weist ein drittes Gleichspannungslastanschlusselement 12, das mit einem ersten elektrischen Anschluss 39 des Kondensators 17 elektrisch leitend verbunden ist und ein viertes Gleichspannungslastanschlusselement 13, das mit einem zweiten elektrischen Anschluss 40 des Kondensators 17 elektrisch leitend verbunden ist, auf. Das dritte Gleichspannungslastanschlusselement 12 weist einen dritten Außenanschlussabschnitt 12a und das vierte Gleichspannungslastanschlusselement 13 einen vierten Außenanschlussabschnitt 13a auf, wobei der dritte und vierte Außenanschlussabschnitt 12a und 13a auf einer ersten Seite B des zweiten Gehäuses 11 angeordnet sind. Wenn das Kondensatormodul 10 mit dem Leistungshalbleitermodul 1 lösbar mechanisch verbunden ist, dann ist die erste Seite B des zweiten Gehäuses 11 der ersten Seite A des ersten Gehäuses 4 zugewandt angeordnet. Das zweite Gehäuse 11 umschließt vorzugsweise lateral und auf einer Grundseite die Kondensatoren. Das zweite Gehäuse 11 weist vorzugsweise eine Grundplatte auf, auf der die Kondensatoren angeordnet sind, was in den Figuren nicht dargestellt ist.

Der dritte und vierte Außenanschlussabschnitt 12a und 13a ist, wie in den Figuren dargestellt, im Rahmen des Ausführungsbeispiels beim Kondensatormodul 10 mehrfach vorhanden, wobei im einfachsten Falle das Kondensatormodul 1 auch nur einen einzelnen dritten und vierten Außenanschlussabschnitt 12a und 13a aufweisen kann. Das zweite Gehäuse 11 besteht vorzugsweise aus einem Metall oder einer Metalllegierung.

Das dritte Gleichspannungslastanschlusselement 12 weist Im Rahmen des Ausführungsbeispiels einen fünften Außenanschlussabschnitt 12b und das vierte Gleichspannungslastanschlusselement 13 einen sechsten Außenanschlussabschnitt 13b auf, wobei der fünfte und sechste Außenanschlussabschnitt 12b und 13b auf der der ersten Seite B des zweiten Gehäuses 11 abgewandt angeordneten zweiten Seite C des zweiten Gehäuses 11 angeordnet ist, wobei zwischen dem dritten und fünften Außenanschlussabschnitt 12a und 12b ein flacher erster Verbindungsabschnitt 12c des dritten Gleichspannungslastanschlusselements 12 und zwischen dem vierten und sechsten Außenanschlussabschnitt 13a und 13b ein flacher zweiter Verbindungsabschnitt 13c des vierten Gleichspannungslastanschlusselements 13 angeordnet ist, wobei zwischen dem ersten und zweiten Verbindungsabschnitt 12c und 13c ein Spalt 41 ausgebildet ist. Im Spalt 41 kann zur Erhöhung der elektrischen Isolationsfestigkeit eine elektrisch nicht leitende Schicht angeordnet sein, die z.B. in Form einer Kunststofffolie ausgebildet sein kann. Die ersten und zweiten Verbindungsabschnitte 12c und 13c sind somit eng voneinander beanstandet angeordnet und weisen somit nur eine kleine Induktivität auf. Die ersten und zweiten Verbindungsabschnitte 12c und 13c bedecken vorzugsweise den mindestens einen Kondensator des Kondensatormoduls. Das dritte und vierte Gleichspannungslastanschlusselement 12 und 13 ist vorzugsweise einstückig ausgebildet. Das Gehäuse 11 weist vorzugsweise auf seiner ersten Seite B Ausnehmungen auf, durch die die Gleichspannungslastanschlusselement 12 und 13 hindurch verlaufen. Die Ausnehmungen sind vorzugsweise jeweilig von einem Rahmenelement 16 umrahmt.

Es sei an dieser Stelle angemerkt, dass im Sinne der vorliegenden Anmeldung unter einem flachen bzw. unter einem flach ausgebildeten Element, ein Element verstanden wird, dessen Dicke klein ist im Vergleich zu seinen sonstigen Abmessungen. Das flache bzw. flach ausgebildete Element kann dabei gebogene und insbesondere abgewinkelte Abschnitte aufweise. Das flache bzw. flach ausgebildete Element kann z.B. in Form eines abgewinkelten, insbesondere eines mehrfach abgewinkelten, Blechstücks vorliegen.

Es ist besonders vorteilhaft, wenn der elektrisch leitende Kontakt des ersten Außenanschlussabschnitts 6a mit dem dritten Außenanschlussabschnitt 12a und der elektrisch leitende Kontakt des zweiten Außenanschlussabschnitts 7a mit dem vierten Außenanschlussabschnitt 13a als Einpresskontakt ausgebildet ist. Vorteilhafte Ausbildungen des Einpresskontakts werden im Folgenden beschrieben.

In FIG 6 ist eine perspektivische Darstellung des Gleichspannungslastanschlusselements 6 dargestellt, wobei vorzugsweise das zweite Gleichspannungslastanschlusselement 7 in analoger Form wie das erste Gleichspannungslastanschlusselement 6 ausgebildet ist und vorzugsweise spiegelsymmetrisch zum ersten Gleichspannungslastanschlusselement 6 ausgebildet ist, so dass auf eine separate Darstellung des zweiten Gleichspannungslastanschlusselement 7 verzichtet wurde. Das erste Gleichspannungslastanschlusselement 6 weist den ersten Außenanschlussabschnitt 6a und den ersten im Inneren des ersten Gehäuses 4 angeordneten ersten Innenanschlussabschnitt 6b auf. Zwischen dem ersten Außenanschlussabschnitt 6a und dem ersten Innenanschlussabschnitt 6b ist ein erster Anschlusselementverbindungsabschnitt 45a abgeordnet. Das zweite Gleichspannungslastanschlusselement 7 weist den zweiten Außenanschlussabschnitt 7a und einen zweiten im Inneren des ersten Gehäuses 4 angeordneten zweiten Innenanschlussabschnitt 7b auf. Zwischen dem zweiten Außenanschlussabschnitt 7a und dem zweiten Innenanschlussabschnitt 7b ist ein zweiter Anschlusselementverbindungsabschnitt 45b abgeordnet.

Der erste Außenanschlussabschnitt 6a weist im Rahmen des Ausführungsbeispiels erste Pressstifte mit einem ersten senkrecht zur axialen Richtung X (siehe FIG 7) der Pressstifte 8 verformbaren jeweiligen ersten Verformungsabschnitt 8a auf und der zweite Außenanschlussabschnitt 7a weist im Rahmen des Ausführungsbeispiels zweite Pressstifte 43 mit einem senkrecht zur axialen Richtung X der zweiten Pressstifte 43 verformbaren jeweiligen zweiten Verformungsabschnitt 43a auf.

Der dritte Außenanschlussabschnitt 12a weist im Rahmen des Ausführungsbeispiels erste Löcher 15 und der vierte Außenanschlussabschnitt 13a zweite Löcher 42 auf.

Es sei an dieser Stelle angemerkt, dass im Rahmen des Ausführungsbeispiels der jeweilige Verformungsabschnitt der ersten und zweiten Pressstifte eine in axiale Richtung des jeweiligen Pressstifts verlaufende durch den Verformungsabschnitt hindurchgehende Ausnehmung aufweist.

Weiterhin sei angemerkt, dass im einfachsten Fall der erste und zweite Außenanschlussabschnitt auch nur jeweilig einen einzelnen Pressstift 8 bzw. 43 aufweisen kann und der dritte und vierte Außenanschlussabschnitt auch nur jeweilig ein einzelnes Loch 15 bzw. 42 aufweisen kann.

Die Gleichspannungslastanschlusselemente 6 und 7 sind vorzugsweise einstückig ausgebildet.

Zur elektrisch leitenden Kontaktierung des Kondensatormodul 10 mit dem Leistungshalbleitermodul 1 bzw. zur Realisierung des Einpresskontakts werden, wie in FIG 7 dargestellt, die ersten Pressstifte 8 in die ersten Löcher 15 und gleichzeitig die zweiten Pressstifte 43 in die zweiten Löcher 42 gedrückt, so dass die ersten Verformungsabschnitte 8a in den ersten Löchern 15 angeordnet sind und in senkrechte Richtung zur axialen Richtung X des ersten Pressstifts gegen die Innenwände 26 der ersten Löcher 15 drücken und solchermaßen einen elektrisch leitenden Kontakt zwischen dem ersten und dritten Außenanschlussabschnitt 6a und 12a bewirken, und die zweiten Verformungsabschnitte 43a in den zweiten Löchern 42 angeordnet sind und in senkrechte Richtung zur axialen Richtung X der zweiten Pressstifte 43 gegen die Innenwände 44 der zweiten Löcher 42 drücken und solchermaßen einen elektrisch leitenden Kontakt zwischen dem zweiten und vierten Außenanschlussabschnitt 7a und 13a bewirken. Die im Rahmen des Ausführungsbeispiels vorhanden beiden weiteren ersten und dritten Außenanschlussabschnitte, welche in FIG 1 und FIG 3 dargestellt sind, und die im Rahmen des Ausführungsbeispiels vorhanden beiden weiteren zweiten und vierten Außenanschlussabschnitte, welche in FIG 1 und FIG 3 dargestellt sind, zur elektrisch leitenden Verbindung der übrigen beiden Substrate des Leistungshalbleitermodul 1 mit den Kondensatoren, werden in analoger Form elektrisch leitend miteinander kontaktiert.

Im Rahmen des Ausführungsbeispiels sind die Pressstifte und die dazu korrespondierenden Löcher kranzförmig angeordnet, was eine besonders einfache Herstellung der Pressstifte ermöglicht. Zur Herstellung der Pressstifte bzw. der Gleichspannungslastanschlusselemente wird vorzugsweise ein Blech entsprechend ausgestanzt und anschließend Abschnitte des ausgestanzten Blechstücks abgewickelt. Die Pressstifte können aber z.B. auch auf das Blechstück aufgeschweißt oder auf andere Art und Weise mit dem Blechstück verbunden sein. Weiterhin können die Pressstifte und die dazu korrespondierenden Löcher selbstverständlich auch andersartig angeordnet sein und z.B. kreuzförmig angeordnet sein.

In FIG 10 ist die elektrische Verbindung zwischen dem Leistungshalbleitermodul 1 und dem Kondensatormodul 10 mit dem Bezugszeichen 32 versehen.

Anschließend wird das Kondensatormodul 10 mit dem Leistungshalbleitermodul 1 lösbar mechanisch verbunden, wobei im Rahmen des Ausführungsbeispiels das Kondensatormodul 10 mit dem Leistungshalbleitermodul 1 lösbar mechanisch verbunden wird, indem das Kondensatormodul 10 mittels einer Schraubverbindung mit dem Leistungshalbleitermodul 1 verbunden wird. Das Leistungshalbleitermodul 1 weist zur Realisierung der Schraubverbindung Löcher 3 und das Kondensatormodul 10 Löcher 14 auf, in die Schrauben eingeführt werden, die das Kondensatormodul 10 mit dem Leistungshalbleitermodul 1 verbinden.

Es sei an dieser Stelle angemerkt, dass z.B. aber auch der erste Außenanschlussabschnitt die Pressstifte und der zweite Außenanschlussabschnitt die Löcher aufweisen kann und der dritte Außenanschlussabschnitt zu den Pressstiften des ersten Außenanschlussabschnitts korrespondierende Löcher und der vierte Außenanschlussabschnitt zu den Löchern des zweiten Außenanschlussabschnitts korrespondierende Pressstifte aufweisen kann. Hierdurch wird eine Verdrehsicherung realisiert bzw. eine elektrische Kontaktierung des Kondensatormoduls mit dem Leistungshalbleitermodul mit fehlerhafter elektrischer Polarität zuverlässig verhindert.

Beim Ausführungsbeispiel ist das Kondensatormodul 10 mit dem Kühlkörper 2 des Leistungshalbleitermoduls 1 lösbar mechanisch, insbesondere mittels einer Schraubverbindung, verbunden, was besonders vorteilhaft ist, da somit das Kondensatormodul 10 und insbesondere die Kondensatoren 17 des Kondensatormodul 10 thermisch leitend an den Kühlkörper 2 des Leistungshalbleitermoduls 1 angekoppelt sind und somit das Kondensatormodul 10 und insbesondere die Kondensatoren 17 des Kondensatormoduls 10 vom Kühlkörper 2 gekühlt werden. Das zweite Gehäuse 11 des Kondensatormoduls 10 besteht, zur Realisierung einer guten thermisch leitenden Ankopplung an das Leistungshalbleitermodul 1, vorzugsweise aus einem Metall bzw. aus einer Metalllegierung. Der Kühlkörper 2 weist zur Realisierung der Schraubverbindung Löcher 3 und das Kondensatormodul 10 Löcher 14 auf, in die Schrauben eingeführt werden, die das Kondensatormodul 10 mit dem Kühlkörper 2 lösbar mechanisch verbinden.

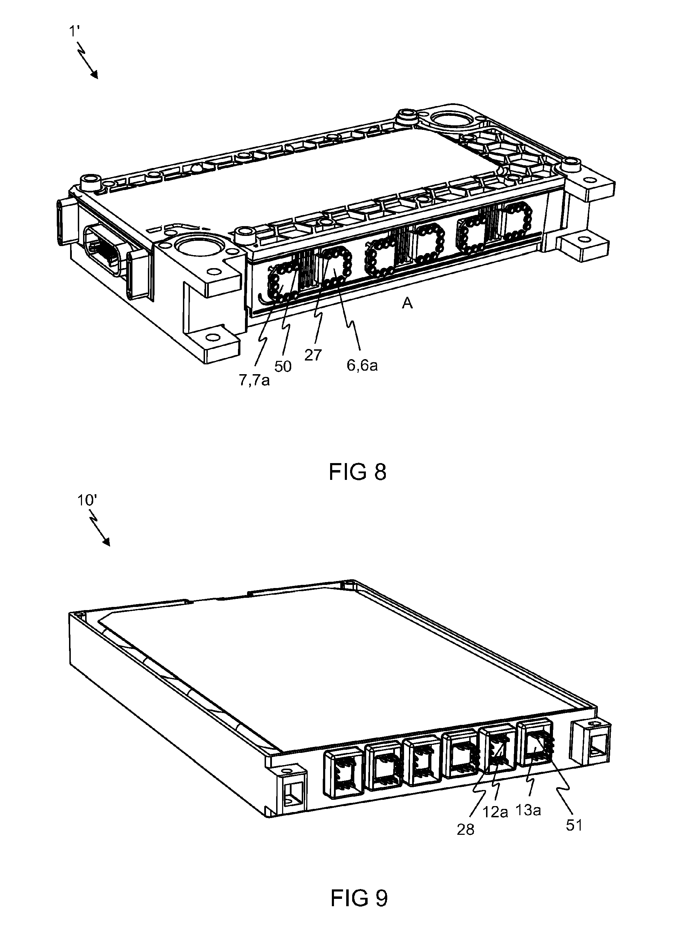

In FIG 8 ist eine perspektivische Darstellung einer weiteren Ausbildung eines eine bauliche Einheit bildenden Leistungshalbleitermoduls 1' und in FIG 9 eine perspektivische Darstellung einer weiteren Ausbildung eines eine bauliche Einheit bildenden Kondensatormoduls 10' dargestellt. Das Leistungshalbleitermodul 1' gemäß FIG 8 entspricht dem Leistungshalbleitermoduls 1 gemäß FIG 1 und das Kondensatormoduls 10' gemäß FIG 9 entspricht dem Kondensatormoduls 10 gemäß FIG 3 bis auf die Merkmal, dass die Pressstifte und die den Pressstiften zugeordneten Löcher der Module vertauscht sind. Der erste Außenanschlussabschnitt 6a weist erste Löcher 27 auf und der zweite Außenanschlussabschnitt 7a weist zweite Löcher 50 auf, wobei der dritte Außenanschlussabschnitt 12a erste Pressstifte 28 mit einem senkrecht zur axialen Richtung der erste Pressstifte 28 verformbaren jeweiligen ersten Verformungsabschnitt und der vierte Außenanschlussabschnitt 13a zweite Pressstifte 51 mit einem senkrecht zur axialen Richtung der zweiten Pressstifte verformbaren jeweiligen zweiten Verformungsabschnitt aufweist, wobei wenn das Kondensatormoduls 10' mit dem Leistungshalbleitermoduls 1' elektrisch leitend kontaktiert ist, die ersten Verformungsabschnitte in den ersten Löchern 27 angeordnet sind und in senkrechte Richtung zur axialen Richtung der ersten Pressstifte gegen die Innenwand der ersten Löcher 27 drücken und solchermaßen den elektrischen leitenden Kontakt zwischen dem ersten und dritten Außenanschlussabschnitt 6a und 12a bewirken, wobei die zweiten Verformungsabschnitte in den zweiten Löchern 50 angeordnet sind und in senkrechte Richtung zur axialen Richtung der zweiten Pressstifte 51 gegen die Innenwand der zweiten Löcher 50 drücken und solchermaßen den elektrischen leitenden Kontakt zwischen dem zweiten und vierten Außenanschlussabschnitt 7a und 13a bewirken.

Die im Rahmen dieses Ausführungsbeispiels vorhanden beiden weiteren ersten und dritten Außenanschlussabschnitte, welche in FIG 8 und FIG 9 dargestellt sind, und die im Rahmen des Ausführungsbeispiels vorhanden beiden weiteren zweiten und vierten Außenanschlussabschnitte, welche in FIG 8 und FIG 9 dargestellt sind, sind zur elektrisch leitenden Verbindung der übrigen beiden Substrate des Leistungshalbleitermodul 1' mit den Kondensatoren des Kondensatormoduls 10', in analoger Form elektrisch leitend miteinander kontaktiert.

Es sei angemerkt, dass im einfachsten Fall der erste und zweite Außenanschlussabschnitt auch nur jeweilig ein einzelnes Loch 27 bzw. 50 aufweisen kann und der dritte und vierte Außenanschlussabschnitt auch nur jeweilig einen einzelnen Pressstift 28 bzw. 51 aufweisen kann.

Es sei weiterhin an dieser Stelle angemerkt, dass der erste Außenanschlussabschnitt des Leistungshalbleitermoduls mit dem dritten Außenanschlussabschnitt des Kondensatormoduls, und der zweite Außenanschlussabschnitt des Leistungshalbleitermoduls mit dem vierten Außenanschlussabschnitt des Kondensatormoduls alternativ z.B. auch mittels einer Schraubverbindung miteinander elektrisch leitend kontaktiert werden können. Entsprechendes gilt für eventuell vorhandene weitere erste, zweite, dritte und vierte Außenanschlussabschnitte.

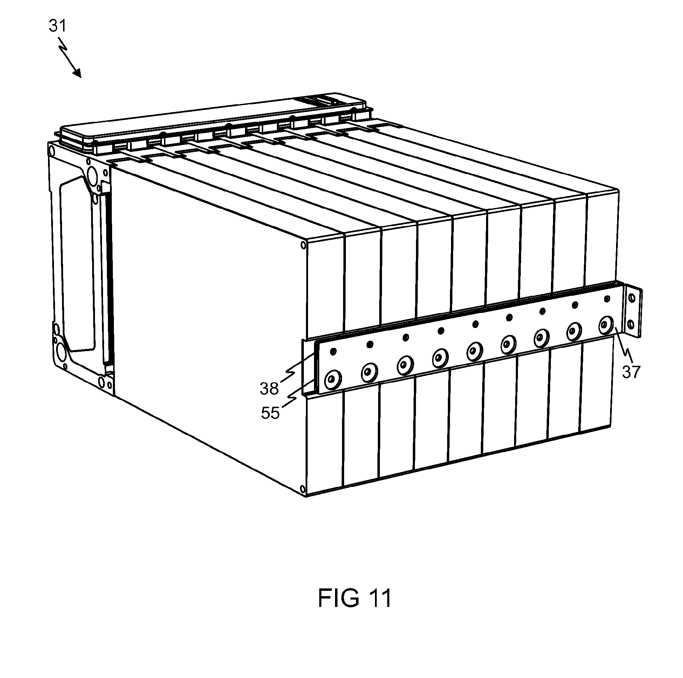

In FIG 10 ist ein Leistungshalbleitereinrichtungssystem 31 in einer Ansicht von vorn und in FIG 11 in einer Ansicht von Hinten auf das Leistungshalbleitereinrichtungssystem 31 dargestellt, wobei das Leistungshalbleitereinrichtungssystem 31 mehrere aneinander angeordnete erfindungsgemäße Leistungshalbleitereinrichtungen 30 aufweist. Die Kühlkörper 2 der Leistungshalbleitereinrichtungen 30 sind miteinander lösbar mechanisch, z.B. mittels einer Schraubverbindung, verbunden. Die Kühlkörper 2 der Leistungshalbleitereinrichtungen 30 sind derart aneinander angeordnet, dass die ersten Flüssigkeitskanalöffnungen 34a und 34b benachbart angeordneter Kühlkörper 2 zueinander fluchtend angeordnet sind und dass die zweiten Flüssigkeitskanalöffnungen 35a und 35b benachbart angeordneter Kühlkörper 2 zueinander fluchtend angeordnet sind. Solchermaßen werden zwei durch die Kühlkörper 2 des Leistungshalbleitereinrichtungssystem 31 in FIG 10 in waagrechte Richtung hindurchverlaufende Kühlkanäle mittels der Flüssigkeitskanalöffnungen ausgebildet.

Die Dicken der Leistungshalbleitermodule und der Kondensatormodule sind dabei vorzugsweise identisch, so dass die Leistungshalbleitereinrichtungen eng aneinander angeordnet werden können.

Vorzugsweise ist zumindest ein Teil der fünften Außenanschlussabschnitte 12b der Leistungshalbleitereinrichtungen 30 elektrisch leitend mit einem ersten elektrisch leitenden Verbindungselement 37 verbunden und zumindest ein Teil der sechsten Außenanschlussabschnitte13b der Leistungshalbleitereinrichtungen 30 elektrisch leitend mit einem zweiten elektrisch leitenden Verbindungselement 38 verbunden, wobei beim Ausführungsbeispiel alle fünften Außenanschlussabschnitte 12b der Leistungshalbleitereinrichtungen 30 elektrisch leitend mit dem ersten elektrisch leitenden Verbindungselement 37 verbunden sind und alle sechsten Außenanschlussabschnitte13b der Leistungshalbleitereinrichtungen 30 elektrisch leitend mit dem zweiten elektrisch leitenden Verbindungselement 38 verbunden sind.

Das erste und das zweite elektrisch leitende Verbindungselement 37 und 38 ist vorzugsweise flach ausgebildet, wobei zwischen dem ersten und dem zweiten elektrisch leitenden Verbindungselement 37 und 38 ein Spalt 55 ausgebildet ist. Im Spalt 55 kann zur Erhöhung der elektrischen Isolationsfestigkeit eine elektrisch nicht leitende Schicht angeordnet sein, die z.B. in Form einer Kunststofffolie ausgebildet sein kann.

Die elektrische Leistung des Leistungshalbleitereinrichtungssystem 31 kann bis zu mehreren MW betragen.

## Patentansprüche

1. Leistungshalbleitereinrichtung mit einem eine bauliche Einheit bildenden Leistungshalbleitermodul (1,1') und einem eine bauliche Einheit bildenden Kondensatormodul (10,10'), wobei das Leistungshalbleitermodul (1,1') ein Substrat (19) und auf dem Substrat (19) angeordnete und mit dem Substrat (19) verbundene Leistungshalbleiterbauelemente (22) aufweist, wobei das Leistungshalbleitermodul (1,1') einen von einer Flüssigkeit durchströmbaren Kühlkörper (2) aufweist, der die Leistungshalbleiterbauelemente (22) kühlt, wobei das Leistungshalbleitermodul (1,1') ein erstes Gehäuse (4) aufweist, durch das ein erstes und ein zweites elektrisch leitendes Gleichspannungslastanschlusselement (6,7), die jeweilig mit mindestens einem Leistungshalbleiterbauelement (22) elektrisch leitend verbunden sind, hindurchverläuft, wobei das erste Gleichspannungslastanschlusselement (6) einen außerhalb des ersten Gehäuses (4) auf einer ersten Seite (A) des ersten Gehäuses (4) angeordneten ersten Außenanschlussabschnitt (6a) und das zweite Gleichspannungslastanschlusselement (7) einen außerhalb des ersten Gehäuses (4) auf der ersten Seite (A) des ersten Gehäuses (4) angeordneten zweiten Außenanschlussabschnitt (7a) aufweist, wobei das Kondensatormodul (10) ein zweites Gehäuse (11) und einen in dem zweiten Gehäuse (11) angeordneten elektrischen Kondensator (17) aufweist, wobei das Kondensatormodul (10) mit dem Leistungshalbleitermodul (1,1') lösbar mechanisch verbunden ist, wobei das Kondensatormodul (10,10') ein drittes Gleichspannungslastanschlusselement (12), das mit einem ersten elektrischen Anschluss (39) des Kondensators (17) elektrisch leitend verbunden ist und ein viertes Gleichspannungslastanschlusselement (13), das mit einem zweiten elektrischen Anschluss (40) des Kondensators (17) elektrisch leitend verbunden ist, aufweist, wobei das dritte Gleichspannungslastanschlusselement (12) einen dritten Außenanschlussabschnitt (12a) und das vierte Gleichspannungslastanschlusselement (13) einen vierten Außenanschlussabschnitt (13a) aufweist, wobei der dritte und vierte Außenanschlussabschnitt (12a,13a) auf einer ersten Seite (B) des zweiten Gehäuses (11) angeordnet ist, wobei die erste Seite (B) des zweiten Gehäuses (11) der ersten Seite (A) des ersten Gehäuses (4) zugewandt angeordnet ist, wobei der erste Außenanschlussabschnitt (6a) mit dem dritten Außenanschlussabschnitt (12a) einen elektrisch leitenden Kontakt aufweist und der zweite Außenanschlussabschnitt (7a) mit dem vierten Außenanschlussabschnitt (13a) einen elektrisch leitenden Kontakt aufweist.

2. Leistungshalbleitereinrichtung nach Anspruch 1, **dadurch gekennzeichnet, dass** das dritte Gleichspannungslastanschlusselement (12) einen fünften Außenanschlussabschnitt (12b) und das vierte Gleichspannungslastanschlusselement (13) einen sechsten Außenanschlussabschnitt (13b) aufweist, wobei der fünfte und sechste Außenanschlussabschnitt (13a, 13b) auf einer der ersten Seite (B) des zweiten Gehäuses (11) abgewandt angeordneten zweiten Seite (C) des zweiten Gehäuses (11) angeordnet ist, wobei zwischen dem dritten und fünften Außenanschlussabschnitt (12a, 12b) ein flacher erster Verbindungsabschnitt (12c) des dritten Gleichspannungslastanschlusselements (12) und zwischen dem vierten und sechsten Außenanschlussabschnitt (13a, 13b) ein flacher zweiter Verbindungsabschnitt (13c) des vierten Gleichspannungslastanschlusselements (13) angeordnet ist, wobei zwischen dem ersten und zweiten Verbindungsabschnitt (12c,13c) ein Spalt (41) ausgebildet ist.

3. Leistungshalbleitereinrichtung nach einem der vorhergehenden Ansprüche, **dadurch gekennzeichnet, dass** der elektrisch leitende Kontakt des ersten Außenanschlussabschnitts (6a) mit dem dritten Außenanschlussabschnitt (12a) und der elektrisch leitende Kontakt des zweiten Außenanschlussabschnitts (7a) mit dem vierten Außenanschlussabschnitt (13a) als Einpresskontakt ausgebildet ist.

4. Leistungshalbleitereinrichtung nach Anspruch 3, **dadurch gekennzeichnet, dass** der dritte Außenanschlussabschnitt (12a) ein erstes Loch (15) und der vierte Außenanschlussabschnitt (13a) ein zweites Loch (42) aufweist, wobei der erste Außenanschlussabschnitt (6a) einen ersten Pressstift (8) mit einem senkrecht zur axialen Richtung (X) des ersten Pressstifts (8) verformbaren ersten Verformungsabschnitt (8a) und der zweite Außenanschlussabschnitt (7a) einen zweiten Pressstift (43) mit einem senkrecht zur axialen Richtung (X) des zweiten Pressstifts (43) verformbaren zweiten Verformungsabschnitt (43a) aufweist, wobei der erste Verformungsabschnitt (8a) im ersten Loch (15) angeordnet ist und in senkrechte Richtung zur axialen Richtung (X) des ersten Pressstifts (8) gegen eine Innenwand (26) des ersten Lochs (15) drückt und solchermaßen den elektrischen leitenden Kontakt zwischen dem ersten und dritten Außenanschlussabschnitt (6a,12a) bewirkt, wobei der zweite Verformungsabschnitt (43a) im zweiten Loch (42) angeordnet ist und in senkrechte Richtung zur axialen Richtung (X) des zweiten Pressstifts (43) gegen eine Innenwand (44) des zweiten Lochs (42) drückt und solchermaßen den elektrischen leitenden Kontakt zwischen dem zweiten und vierten Außenanschlussabschnitt (7a,13a) bewirkt.

5. Leistungshalbleitereinrichtung nach Anspruch 3, **dadurch gekennzeichnet, dass** der erste Außenanschlussabschnitt (6a) ein erstes Loch (27) und der zweite Außenanschlussabschnitt (7a) ein zweites Loch (50) aufweist, wobei der dritte Außenanschlussabschnitt (12a) einen ersten Pressstift (28) mit einem senkrecht zur axialen Richtung (X) des ersten Pressstifts (28) verformbaren ersten Verformungsabschnitt und der vierte Außenanschlussabschnitt (13a) einen zweiten Pressstift (51) mit einem senkrecht zur axialen Richtung (X) des zweiten Pressstifts (51) verformbaren zweiten Verformungsabschnitt aufweist, wobei der erste Verformungsabschnitt im ersten Loch (27) angeordnet ist und in senkrechte Richtung zur axialen Richtung (X) des ersten Pressstifts (28) gegen eine Innenwand des ersten Lochs (27) drückt und solchermaßen den elektrischen leitenden Kontakt zwischen dem ersten und dritten Außenanschlussabschnitt (6a,12a) bewirkt, wobei der zweite Verformungsabschnitt im zweiten Loch (50) angeordnet ist und in senkrechte Richtung zur axialen Richtung (X) des zweiten Pressstifts (51) gegen eine Innenwand des zweiten Lochs (50) drückt und solchermaßen den elektrischen leitenden Kontakt zwischen dem zweiten und vierten Außenanschlussabschnitt (7a,13a) bewirkt.

6. Leistungshalbleitereinrichtung nach einem der vorhergehenden Ansprüche, **dadurch gekennzeichnet, dass** das Kondensatormodul (10,10') mit dem Leistungshalbleitermodul (1,1') lösbar mechanisch verbunden ist, indem das Kondensatormodul (10,10') mit dem Kühlkörper (2) des Leistungshalbleitermoduls (1,1') lösbar mechanisch verbunden ist.

7. Leistungshalbleitereinrichtungssystem, wobei das Leistungshalbleitereinrichtungssystem (31) mehrere aneinander angeordnete Leistungshalbleitereinrichtungen (30) nach einem der vorhergehenden Ansprüche aufweist, wobei die Kühlkörper (2) der Leistungshalbleitereinrichtungen (30) miteinander lösbar mechanisch verbunden sind und die Kühlkörper (2) jeweilig erste Flüssigkeitskanalöffnungen (34a,34b) und zweite Flüssigkeitskanalöffnungen (35a,35b) aufweisen, wobei die Kühlkörper (2) der Leistungshalbleitereinrichtungen (30) derart aneinander angeordnet sind, dass die ersten Flüssigkeitskanalöffnungen (34a,34b) benachbart angeordneter Kühlkörper (2) zueinander fluchtend angeordnet sind und dass die zweiten Flüssigkeitskanalöffnungen (35a,35b) benachbart angeordneter Kühlkörper (2) zueinander fluchtend angeordnet sind.

8. Leistungshalbleitereinrichtungssystem nach Anspruch 7, **dadurch gekennzeichnet, dass** bei den Leistungshalbleitereinrichtungen (30) des Leistungshalbleitereinrichtungssystems (31) das dritte Gleichspannungslastanschlusselement (12) einen fünften Außenanschlussabschnitt (12b) und das vierte Gleichspannungslastanschlusselement (13) einen sechsten Außenanschlussabschnitt (13b) aufweist, wobei der fünfte und sechste Außenanschlussabschnitt (12b, 13b) auf einer der ersten Seite (B) des zweiten Gehäuses (11) gegenüberliegend angeordneten zweiten Seite (C) des zweiten Gehäuses (11) angeordnet ist, wobei zwischen dem dritten und fünften Außenanschlussabschnitt (12a,12b) ein flacher erster Verbindungsabschnitt (12c) des dritten Gleichspannungslastanschlusselements (12) und zwischen dem vierten und sechsten Außenanschlussabschnitt (13a,13b) ein flacher zweiter Verbindungsabschnitt (13c) des vierten Gleichspannungslastanschlusselements (13) angeordnet ist, wobei zwischen dem ersten und zweiten Verbindungsabschnitt (12c,13c) ein Spalt (55) ausgebildet ist, wobei zumindest ein Teil der fünften Außenanschlussabschnitte (12b) der Leistungshalbleitereinrichtungen (30) elektrisch leitend mit einem ersten elektrisch leitenden Verbindungselement (37) verbunden sind und zumindest ein Teil der sechsten Außenanschlussabschnitte (13b) der Leistungshalbleitereinrichtungen (30) elektrisch leitend mit einem zweiten elektrisch leitenden Verbindungselement (38) verbunden sind.

9. Leistungshalbleitereinrichtungssystem nach Anspruch 8, **dadurch gekennzeichnet, dass** das erste und das zweite elektrisch leitende Verbindungselement (37,38) flach ausgebildet ist und zwischen dem ersten und dem zweiten elektrisch leitenden Verbindungselement (37,38) ein Spalt (55) ausgebildet ist.
